# EUROPÄISCHE PATENTSCHRIFT

(11) **EP 2 927 762 B1**
(45) Veröffentlichungstag und Bekanntmachung des Hinweises auf die Patenterteilung: **17.06.2020**
(21) Anmeldenummer: 15162001.0
(22) Anmeldetag: 31.03.2015
(51) Int. Cl.: G05B 19/042, H05K 1/02

(54) **ELEKTRISCHES STEUERGERÄT, SICHERHEITSMODUL UND STEUERGERÄTESYSTEM**
ELECTRIC CONTROL DEVICE, SECURITY MODULE AND CONTROL DEVICE SYSTEM
APPAREIL DE COMMANDE ÉLECTRIQUE, MODULE DE SÉCURITÉ ET SYSTÈME D'APPAREIL DE COMMANDE

(30) Priorität: 01.04.2014 DE 102014206222
(43) Veröffentlichungstag der Anmeldung: 07.10.2015
(73) Patentinhaber: Schmidhauser AG, 8590 Romanshorn (CH)
(72) Erfinder: Naturale, Luigi, 78464 Konstanz (DE)
(74) Vertreter: Patentanwälte Ruff, Wilhelm, Beier, Dauster & Partner mbB

(56) Entgegenhaltungen:
- EP-A2- 2 620 820
- WO-A1-2007/118479
- DE-A1- 10 308 642
- US-A1- 2012 146 463

## Beschreibung

Die Erfindung betrifft ein elektrisches Steuergerät, das in einem sicheren Betriebszustand und in einem normalen Betriebszustand betreibbar ist, und ein Steuergerätesystem.

Steuergeräte, die sicherheitstechnische Anforderungen erfüllen müssen, können neben einem normalen Betriebszustand auch einen so genannten sicheren Betriebszustand aufweisen bzw. einnehmen. In dem normalen Betriebszustand kann beispielsweise mittels einem durch das Steuergerät angesteuerten Elektromotor ein Drehmoment erzeugt werden, eine zu bewegende Komponente mit einer bestimmten Geschwindigkeit und/oder einem bestimmten Geschwindigkeitsprofil bewegt werden, usw. In dem sicheren Betriebszustand kann beispielsweise mittels hard- und/oder softwareseitiger Maßnahmen verhindert werden, dass ein Drehmoment erzeugt wird (Safe Torque Off (STO)), eine zu bewegende Komponente mit einer bestimmten Geschwindigkeit und/oder einem bestimmten Geschwindigkeitsprofil bewegt wird, usw.. Das Umschalten zwischen normalem und sicherem Zustand kann beispielsweise anhand von extern zugeführten Signalen erfolgen. Im Übrigen sei insoweit auch auf die einschlägige Fachliteratur, insbesondere zur funktionalen Sicherheit, verwiesen.

Die WO 2007/118479 A1 zeigt eine elektronische Baugruppe und ein Verfahren zum zumindest teilweise Verschrotten der elektronischen Baugruppe, wobei die elektronische Baugruppe eine Sollabtrennungskante zum mechanischen, irreversiblen Abtrennen eines Abtrennungsteils der Baugruppe von einem Baugruppenrest aufweist, wobei sowohl das Abtrennungsteil als auch der Baugruppenrest jeweils für einen bestimmungsgemäßen elektrotechnischen Betrieb der Baugruppe wesentlich zusammenwirkende Schaltungsteile aufweisen. Durch das Abtrennen des Abtrennungsteils kann der elektrotechnische Betrieb der Baugruppe dauerhaft deaktiviert werden.

Die DE 103 08 642 A1 zeigt ein Herstellungsverfahren von Leiterplatten eines Umrichters für Antriebe geringer Leistung.

Die EP 2 620 820 A2 zeigt eine Modulanordnung mit einer Anzahl von in einer Reihe angeordneten Reihenmodulen, die wenigstens teilweise als Ausgangsmodule zum Ansteuern von Aktoren in der Automatisierungstechnik ausgebildet sind. Zumindest ein Reihenmodul ist als Sicherheitsmodul ausgebildet, das mit wenigstens einem zugeordneten Ausgangsmodul ein sicheres Segment bildet.

Die US 2012/0146463 A1 zeigt eine rekonfigurierbare elektronische Schaltung mit einem Substrat, auf dem ein erster und ein zweiter Schaltungsteil angeordnet sind. Weiter ist ein Separierungsmechanismus vorgesehen, der ein Separieren der beiden Schaltungsteile ermöglicht, wobei bei einem Separieren der Schaltungsteile eine Funktion der elektronischen Schaltung verändert wird.

Der Erfindung liegt die Aufgabe zugrunde, ein elektrisches Steuergerät und ein Steuergerätesystem zur Verfügung zu stellen, die eine möglichst einfache und kostengünstige Implementierung sicherheitstechnischer Funktionen ermöglichen.

Der Erfindung löst diese Aufgabe durch ein elektrisches Steuergerät nach Anspruch 1 und ein Steuergerätesystem nach Anspruch 5.

Das elektrisches Steuergerät ist in einem sicheren Betriebszustand, beispielsweise Safe Torque Off (STO), Safely limited Speed (SLS), Safely limited Increment (SLI), Safe operating Stop (SOS), usw., und in einem normalen Betriebszustand betreibbar. Der normale Betriebszustand kann keinen besonderen Sicherheitsanforderungen unterliegen bzw. entsprechen. Insoweit sei auch auf die einschlägige Fachliteratur verwiesen.

Das elektrische Steuergerät weist eine Sicherheitssignalquelle auf, die dazu ausgebildet ist, ein elektrisches Sicherheitssignal zu erzeugen. Das Sicherheitssignal kann ein zeitlich unveränderliches Signal sein. Alternativ kann das Sicherheitssignal ein zeitlich veränderliches Signal sein, beispielsweise eine Rechteckspannung oder ein Signal mit vorgegebenem zeitlichem Signalverlauf.

Das elektrische Steuergerät weist weiter eine Überwachungseinrichtung mit einem Überwachungseingang auf, die überwacht, ob das Sicherheitssignal an dem Überwachungseingang anliegt. Wenn das Sicherheitssignal beispielsweise nicht mit dem erwarteten Pegel und/oder dem erwarteten zeitlichen Verlauf an dem Überwachungseingang anliegt, ist die Überwachungseinrichtung dazu ausgebildet, den sicheren Betriebszustand zu bewirken, beispielsweise indem die Überwachungseinrichtung eine Erzeugung einer Versorgungsspannung von zur Ansteuerung von Leistungshalbleitern dienenden Treibereinheiten beendet, so dass mittels der Treibereinheiten keine drehmomentbewirkende Ansteuersignale mehr erzeugbar sind.

Das elektrische Steuergerät weist weiter eine, insbesondere mehrlagige, Leiterplatte auf, auf der, beispielsweise in Form von elektrischen Schaltungen, die Sicherheitssignalquelle und die Überwachungseinrichtung angeordnet sein können. Die Leiterplatte weist mindestens eine Innenlage auf. Weiter weist die Leiterplatte einen, insbesondere randseitigen, Brückenabschnitt auf, der bei einer, insbesondere definierten, Kraftbeaufschlagung an Sollbruchstellen, insbesondere irreversibel, von der Leiterplatte abgetrennt bzw. abgebrochen wird. Die Leiterplatte weist weiter eine auf der Innenlage verlaufende Leiterbahn auf, die signaltechnisch zwischen die Sicherheitssignalquelle und den Überwachungseingang der Überwachungseinrichtung eingeschleift ist. Zwischen der Sicherheitssignalquelle und dem Überwachungseingang der Überwachungseinrichtung können weitere Leiterbahnen, Leiter, Bauelemente, usw. vorgesehen sein. Wesentlich ist lediglich, dass die Leiterbahn auf der Innenlage der Leiterplatte notwendiger Bestandteil der Signalverbindung, d.h. der elektrischen Verbindung, zwischen der Sicherheitssignalquelle und dem Überwachungseingang der Überwachungseinrichtung ist. Die Leiterbahn auf der Innenlage der Leiterplatte ist derart über den Brückenabschnitt geführt, dass eine Signalverbindung zwischen der Sicherheitssignalquelle und dem Überwachungseingang der Überwachungseinrichtung unterbrochen ist, wenn der Brückenabschnitt von der Leiterplatte abgetrennt ist. Ein einfach vorzunehmendes Abtrennen des Brückenabschnitts führt folglich zwingend dazu, dass das elektrische Steuergerät seinen sicheren Betriebszustand einnimmt, wenn keine weiteren Maßnahmen getroffen werden.

Die Sollbruchstellen können mittels Einkerbungen oder Einfräsungen in der Leiterplatte vorgegeben sein.

Die Leiterplatte weist angrenzend an bzw. benachbart zu dem Brückenabschnitt einen Leiterplatten(direkt)steckverbinder mit einem oder mehreren Anschlusspolen auf, auf den ein Sicherheitsmodul mit korrespondierendem Steckverbinder, beispielsweise in Form einer Buchsenleiste, aufsteckbar ist, wenn der Brückenabschnitt von der Leiterplatte abgetrennt ist. Ein oder mehrere Anschlusspole des Leiterplatten(direkt)steckverbinders sind elektrisch mit dem Überwachungseingang der Überwachungseinrichtung verbunden, so dass das Sicherheitsmodul in gestecktem Zustand gegebenenfalls das Sicherheitssignal derart erzeugen kann, dass an dem Überwachungseingang das vom Sicherheitsmodul erzeugte Sicherheitssignal anliegt, obwohl die direkte Signalverbindung zwischen Sicherheitssignalquelle und Überwachungseinrichtung aufgetrennt ist.

Das elektrische Steuergerät kann ein Frequenzumrichter sein.

Das elektrische Steuergerät kann ein Steuergerätegehäuse, beispielsweise aus Kunststoff, aufweisen, wobei die Sicherheitssignalquelle, die Überwachungseinrichtung und die Leiterplatte innerhalb des Steuergerätegehäuses angeordnet sind. Das Steuergerätegehäuse kann einen Gehäuseabschnitt mit einer Öffnung aufweisen. Auch die Leiterplatte kann eine Öffnung aufweisen, die bei in dem Steuergerätegehäuse bestimmungsgemäß angeordneter Leiterplatte derart geometrisch bzw. räumlich mit der Öffnung des Steuergerätegehäuses korrespondiert, dass ein Werkzeug, beispielsweise ein herkömmlicher Schraubendreher, zunächst durch die Öffnung des Steuergerätegehäuses und dann auch durch die Öffnung der Leiterplatte derart durchsteckbar ist, dass der Brückenabschnitt und der Gehäuseabschnitt mittels des Werkzeugs kraftbeaufschlagbar sind, beispielsweise aufgrund einer (Dreh-) Bewegung des Werkzeugs von der Überwachungseinrichtung weg, wobei bei einer Kraftbeaufschlagung der Brückenabschnitt von der Leiterplatte abgetrennt wird und der Gehäuseabschnitt von dem Steuergerätegehäuse abgetrennt wird, so dass beispielsweise der Leiterplattendirektsteckverbinder freigelegt ist.

Die Erfindung betrifft weiter ein Steuergerätesystem mit einem oben genannten Steuergerät und einem Sicherheitsmodul.

Das Sicherheitsmodul dient zum Aufstecken auf den Leiterplatten(direkt)steckverbinder des oben genannten Steuergeräts. Das Sicherheitsmodul ist dazu ausgebildet, das Sicherheitssignal in Abhängigkeit von sicherheitsfunktionsrelevanten Signalen, die beispielswiese über den Leiterplatten(direkt)steckverbinder oder über Anschlüsse des Sicherheitsmoduls zugeführt werden, derart zu erzeugen, dass der sichere Betriebszustand oder der normale Betriebszustand bewirkt wird. Bei den sicherheitsfunktionsrelevanten Signalen kann es sich beispielsweise um Signale von Lichtschranken, Signale von Not-Aus-Schaltern, usw. handeln.

Die Erfindung wird nachfolgend unter Bezugnahme auf die Zeichnungen detailliert beschrieben. Hierbei zeigen schematisch:
Fig. 1 eine Leiterplatte eines erfindungsgemäßen Steuergeräts und ein Sicherheitsmodul und
Fig. 2 ein Steuergerätegehäuse des erfindungsgemäßen Steuergeräts.

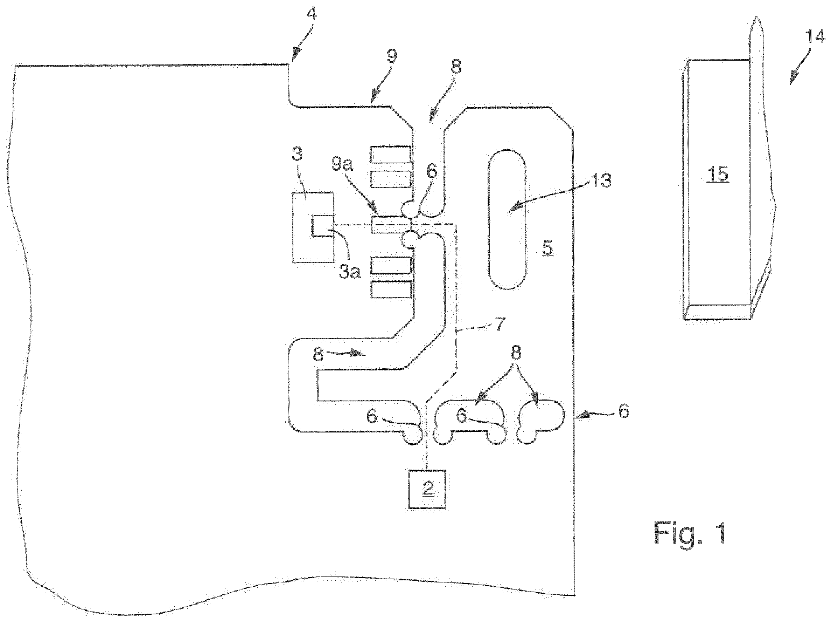

Fig. 1 zeigt eine Leiterplatte 4 als Bestandteil eines erfindungsgemäßen Steuergeräts 1 in Form eines Frequenzumrichters und ein Sicherheitsmodul 14. Es versteht sich, dass das Steuergerät 1 weitere, nicht näher gezeigte herkömmliche Komponenten aufweisen kann.

Das elektrische Steuergerät 1 ist in einem sicheren Betriebszustand und in einem normalen Betriebszustand betreibbar.

Das Steuergerät 1 weist eine auf der Leiterplatte 4 angeordnete Sicherheitssignalquelle 2 auf, die beispielsweise dazu ausgebildet ist, unabhängig vom Betriebszustand ein elektrisches Sicherheitssignal in Form einer Rechteckspannung mit bekannter Frequenz zu erzeugen. Das Sicherheitssignal kann im einfachsten Fall auch eine konstante Spannung mit definiertem Pegel aufweisen.

Das Steuergerät 1 weist weiter eine Überwachungseinrichtung 3 mit einem Überwachungseingang 3a auf, die überwacht, ob das Sicherheitssignal an dem Überwachungseingang 3a anliegt. Wenn das Sicherheitssignal nicht an dem Überwachungseingang 3a anliegt, stellt die Überwachungseinrichtung 3 den sicheren Betriebszustand ein.

Die Sicherheitssignalquelle 2 und die Überwachungseinrichtung 3 können beispielsweise durch einen Mikroprozessor oder einen Signalprozessor verkörpert sein, wobei die Sicherheitssignalquelle 2 und die Überwachungseinrichtung 3 durch funktionale Blöcke aus Hard- und Software des Mikroprozessors bzw. Signalprozessors gebildet sind. Die Sicherheitssignalquelle 2 und die Überwachungseinrichtung 3 können alternativ auch als Hardwarebausteine verwirklicht sein.

Das Steuergerät 1 weist weiter eine Leiterplatte 4 auf, auf der die Sicherheitssignalquelle 2 und die Überwachungseinrichtung 3 angeordnet sind. Die Leiterplatte 4 ist mehrlagig aufgebaut und weist mindestens eine Innenlage auf. Weiter ist randseitig ein Brückenabschnitt 5 vorgesehen, wobei der Brückenabschnitt 5 bei einer Kraftbeaufschlagung an Sollbruchstellen 6 von der Leiterplatte 4 abgetrennt wird.

Eine auf der Innenlage der Leiterplatte 4 verlaufende Leiterbahn 7 ist zwischen die Sicherheitssignalquelle 2 und den Überwachungseingang 3a der Überwachungseinrichtung 3 eingeschleift. Die Leiterbahn 7 ist derart auf der Innenlage über den Brückenabschnitt 5 geführt, dass eine Signalverbindung bzw. elektrische Verbindung zwischen der Sicherheitssignalquelle 2 und dem Überwachungseingang 3a der Überwachungseinrichtung 3 sicher unterbrochen wird, wenn der Brückenabschnitt 5 von der Leiterplatte 4 abgetrennt wird.

Die Sollbruchstellen 6 sind mittels Einfräsungen 8 in der Leiterplatte 4 definiert.

Die Leiterplatte 4 weist angrenzend an den Brückenabschnitt 5 einen Leiterplattendirektsteckverbinder 9 auf, auf den eine Buchsenleiste 15 eines Sicherheitsmoduls 14 aufsteckbar ist, wenn der Brückenabschnitt 5 von der Leiterplatte 4 abgetrennt ist. Ein Anschlusspol 9a des Leiterplattendirektsteckverbinders 9 ist elektrisch mit dem Überwachungseingang 3a der Überwachungseinrichtung 3 verbunden, so dass das Sicherheitsmodul 14 den Überwachungseingang 3a mit einem mittels des Sicherheitsmoduls 14 erzeugten (Sicherheitssteuer-) Signals beaufschlagen kann.

Das Sicherheitsmodul 14 ist dazu ausgebildet, das Sicherheitssteuersignal in Abhängigkeit von sicherheitsfunktionsrelevanten Signalen derart zu erzeugen, dass der sichere Betriebszustand oder der normale Betriebszustand bewirkt wird. Die sicherheitsfunktionsrelevanten Signale können über weitere Anschlusspole des Leiterplattendirektsteckverbinders 9 zugeführt werden und/oder das Sicherheitsmodul 14 kann eigene Anschlüsse zur Zuführung der sicherheitsfunktionsrelevanten Signale aufweisen. Ein sicherheitsfunktionsrelevantes Signal kann beispielsweise ein Lichtschrankensignal sein, das anzeigt, ob sich ein Bediener innerhalb eines sicherheitsrelevanten Bereichs einer Anlage aufhält. Wenn das Lichtschrankensignal anzeigt, dass sich ein Bediener in dem sicherheitsrelevanten Bereich aufhält, kann das Sicherheitsmodul 14 das Signal am Anschlusspol 9a derart erzeugen, beispielsweise mit einem konstanten Low-oder High-Pegel, dass die Überwachungseinrichtung 3 einen sicheren Zustand bewirkt, indem beispielsweise verhindert wird, dass ein mittels des Steuergeräts 1 angesteuerter Elektromotor ein Drehmoment erzeugt.

Das Sicherheitsmodul 14 kann beispielsweise mit einer externen Steuerung mit Safety-Funktionalität gekoppelt sein. Der Frequenzumrichter 1 kann über I/O-Eingänge und/oder über einen Feldbus mit einer externen Steuerung ohne Safety-Funktionalität gekoppelt sein, wobei die Steuerung ohne Safety-Funktionalität den normalen Betrieb des Frequenzumrichters 1 steuert, beispielsweise eine Drehzahl, ein Drehmoment usw. vorgibt. Bei entferntem Brückenabschnitt 5 und Verwendung des Sicherheitsmoduls 14 kann die externe Steuerung mit Safety-Funktionalität durch geeignete Ansteuerung des Sicherheitsmoduls 14 den sicheren Zustand, beispielswiese in Form eines STO-Zustands, erzwingen, und zwar unabhängig von der Steuerung des Frequenzumrichters 1 durch die externe Steuerung ohne Safety-Funktionalität.

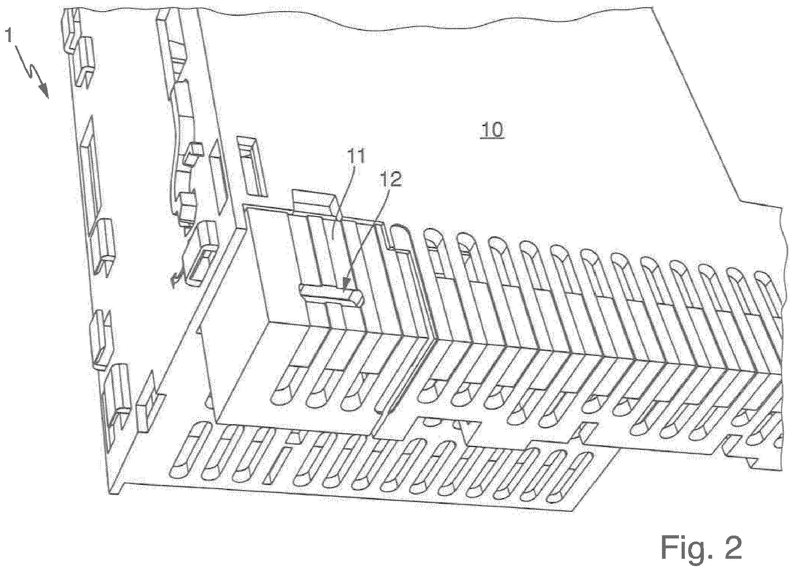

Fig. 2 zeigt ein Steuergerätegehäuse 10 des erfindungsgemäßen Steuergeräts 1. Die Sicherheitssignalquelle 2, die Überwachungseinrichtung 3 und die Leiterplatte 4 sind innerhalb des Steuergerätegehäuses 10 angeordnet.

Das Steuergerätegehäuse 10 weist einen Gehäuseabschnitt 11 mit einer Öffnung 12 auf. Die Leiterplatte 4 weist ebenfalls eine Öffnung 13 auf, die bei in dem Steuergerätegehäuse 10 angeordneter Leiterplatte 4 derart geometrisch mit der Öffnung 12 des Steuergerätegehäuses korrespondiert, dass ein Werkzeug sowohl durch die Öffnung 12 des Steuergerätegehäuses 10 als auch durch die Öffnung 13 der Leiterplatte 4 derart durchsteckbar ist, dass der Brückenabschnitt 5 und der Gehäuseabschnitt 11 mittels des Werkzeugs kraftbeaufschlagbar sind, wobei bei einer Kraftbeaufschlagung der Brückenabschnitt 5 von der Leiterplatte 4 abgetrennt wird und der Gehäuseabschnitt 11 von dem Steuergerätegehäuse 10 abgetrennt wird, so dass mittels eines einzelnen Arbeitsgangs der Leiterplattendirektsteckverbinder 9 zugänglich gemacht werden kann. Für diesen Fall kann dann von außen das Sicherheitsmodul 14 aufgesteckt werden.

Erfindungsgemäß werden ein oder mehrere Sicherheitssignale über das Leiterbild und die Leiterplattenkontur der Leiterplatte 4 ohne Einsatz von zusätzlichen Komponenten gebrückt, d.h.es sind keine hierfür speziell vorgesehenen Stecker, Brücken (Jumper) notwendig.

Wenn der Anwender ein aufsteckbares Sicherheitsmodul 14 einsetzen möchte, wird die Signalverbindung durch die Leiterbahn 7 rückstandslos durch Abbrechen des Brückenabschnitts 5 aufgetrennt. Durch Aufstecken des Sicherheitsmoduls 14 kann der Sicherheitspfad aktiv genutzt werden. Eine parallele Nutzung von überbrückten Sicherheitssignalen und aktivem Sicherheitsmodul 14 wird verhindert.

Das Sicherheitsmodul 14 greift beispielswiese in die Steuerung einer Leistungselektronik des Steuergeräts 1 ein und schaltet Steuersignale ab, wenn der sichere Zustand eingenommen werden muss.

Da die Leiterbahn 7 auf einer Innenlage der Leiterplatte 4 geführt ist, sind das oder die Sicherheitssignale nicht durch eine fremde bzw. von außen zugeführte Spannung aktivierbar.

Die Leiterplatte 4 weist die Kontur und die Pads bzw. Anschlusspole für die Aufnahme des der Buchsenleiste bzw. des Gegensteckers 15 des Sicherheitsmoduls 14 auf.

## Patentansprüche

1. Elektrisches Steuergerät (1), das in einem sicheren Betriebszustand und in einem normalen Betriebszustand betreibbar ist, aufweisend:
- eine Sicherheitssignalquelle (2), die dazu ausgebildet ist, ein elektrisches Sicherheitssignal zu erzeugen,
- eine Überwachungseinrichtung (3) mit einem Überwachungseingang (3a), die dazu ausgebildet ist, zu überwachen, ob das Sicherheitssignal an dem Überwachungseingang (3a) anliegt, und für den Fall, dass das Sicherheitssignal nicht an dem Überwachungseingang (3a) anliegt, den sicheren Betriebszustand einzustellen, und
- eine Leiterplatte (4), aufweisend:
- mindestens eine Innenlage,
- einen Brückenabschnitt (5), wobei der Brückenabschnitt (5) bei einer Kraftbeaufschlagung an Sollbruchstellen (6) von der Leiterplatte (4) abgetrennt wird, und
- eine auf der Innenlage verlaufende Leiterbahn (7), die zwischen die Sicherheitssignalquelle (2) und den Überwachungseingang (3a) der Überwachungseinrichtung (3) eingeschleift ist und die derart über den Brückenabschnitt (5) geführt ist, dass eine Signalverbindung zwischen der Sicherheitssignalquelle (2) und dem Überwachungseingang (3a) der Überwachungseinrichtung (3) unterbrochen ist, wenn der Brückenabschnitt (5) von der Leiterplatte (4) abgetrennt ist,
**dadurch gekennzeichnet, dass**
- die Leiterplatte (4) angrenzend an den Brückenabschnitt (5) einen Leiterplattendirektsteckverbinder (9) aufweist, auf den ein Sicherheitsmodul (14) aufsteckbar ist, wenn der Brückenabschnitt (5) von der Leiterplatte (4) abgetrennt ist, wobei ein Anschlusspol (9a) des Leiterplattendirektsteckverbinders (9) elektrisch mit dem Überwachungseingang (3a) der Überwachungseinrichtung (3) verbunden ist.

2. Elektrisches Steuergerät nach Anspruch 1, **dadurch gekennzeichnet, dass**
- die Sollbruchstellen (6) mittels Einkerbungen oder Einfräsungen (8) in der Leiterplatte (4) vorgegeben sind.

3. Elektrisches Steuergerät nach Anspruch 1 oder 2, **dadurch gekennzeichnet, dass**
- das elektrische Steuergerät ein Frequenzumrichter ist.

4. Elektrisches Steuergerät nach einem der vorhergehenden Ansprüche, **gekennzeichnet durch**,
- ein Steuergerätegehäuse (10),
- wobei die Sicherheitssignalquelle (2), die Überwachungseinrichtung (3) und die Leiterplatte (4) innerhalb des Steuergerätegehäuses (10) angeordnet sind,
- wobei das Steuergerätegehäuse (10) einen Gehäuseabschnitt (11) mit einer Öffnung (12) aufweist, und
- wobei die Leiterplatte (4) eine Öffnung (13) aufweist, die bei in dem Steuergerätegehäuse (10) angeordneter Leiterplatte (4) derart geometrisch mit der Öffnung (12) des Steuergerätegehäuses korrespondiert, dass ein Werkzeug sowohl durch die Öffnung (12) des Steuergerätegehäuses (10) als auch durch die Öffnung (13) der Leiterplatte (4) derart durchsteckbar ist, dass der Brückenabschnitt (5) und der Gehäuseabschnitt (11) mittels des Werkzeugs kraftbeaufschlagbar sind, wobei bei einer Kraftbeaufschlagung der Brückenabschnitt (5) von der Leiterplatte (4) abgetrennt wird und der Gehäuseabschnitt (11) von dem Steuergerätegehäuse (10) abgetrennt wird.

5. Steuergerätesystem, aufweisend
- ein elektrisches Steuergerät (1) nach einem der Ansprüche 1 bis 4 und
- ein Sicherheitsmodul (14) zum Aufstecken auf den Leiterplattensteckverbinder (9) des Steuergeräts (1),
- wobei das Sicherheitsmodul (14) dazu ausgebildet ist, das Sicherheitssignal in Abhängigkeit von sicherheitsfunktionsrelevanten Signalen derart zu erzeugen, dass der sichere Betriebszustand oder der normale Betriebszustand bewirkt wird.

## Claims

1. Electric control device (1) which is operable in a safe operating state and in a normal operating state, comprising:
- a security signal source (2) which is configured to generate an electric security signal,
- a monitoring device (3) comprising a monitoring input (3a) which is configured to monitor whether or not the security signal is applied to the monitoring input (3a) and, in case that the security signal is not applied to the monitoring input (3a), to cease the safe operating state, and
- a circuit board (4), comprising:
- at least one inner layer,
- a bridge section (5), wherein the bridge section (5), upon force application, is separated from the circuit board (4) on predetermined breaking points (6), and
- a conducting path (7) extending on the inner layer, which path is connected between the security signal source (2) and the monitoring input (3a) of the monitoring device (3) and is led across the bridge section (5) such that a signal connection between the security signal source (2) and the monitoring input (3a) of the monitoring device (3) is disconnected when the bridge section (5) is separated from the circuit board (4), **characterized in that**
- the circuit board (4), adjacent to the bridge section (5), has a circuit board direct plug connector (9) onto which a security module (14) is attachable, when the bridge section (5) is separated from the circuit board (4), wherein a pole connector (9a) of the circuit board direct plug connector (9) is electrically connected to the monitoring input (3a) of the monitoring device (3).

2. Electric control device according to claim 1, **characterized in that**
- the predetermined breaking points (6) are predefined by indentations or milled recesses (8) in the circuit board (4).

3. Electric control device according to claim 1 or 2, **characterized in that**
- the electric control device is a frequency converter.

4. Electric control device according to any of the preceding claims, **characterized by**
- a control device housing (10),
- wherein the security signal source (2), the monitoring device (3) and the circuit board (4) are disposed within the control device housing (10),
- wherein the control device housing (10) has a housing section (11) comprising an opening (12), and
- wherein the circuit board (4) comprises an opening (13) which, with the circuit board (4) disposed in the control device housing (10), corresponds geometrically to the opening (12) of the control device housing such that a tool can be passed both through the opening (12) of the control device housing (10) and through the opening (13) of the circuit board (4) such that force can be applied to the bridge section (5) and the housing section (11) using the tool, wherein, upon force application, the bridge section (5) is separated from the circuit board (4) and the housing section (11) is separated from the control device housing (10).

5. Control device system, comprising
- an electric control device (1) according to any of the claims 1 to 4, and
- a security module (14) to be attached onto the circuit board plug connector (9) of the control device (1),
- wherein the security module (14) is configured to generate the security signal in response to security function relevant signals such that the safe operating state or the normal operating state is caused.

## Revendications

1. Contrôleur électrique (1) qui peut fonctionner dans un état opérationnel sécurisé et dans un état opérationnel normal, comprenant :
- une source de signal de sécurité (2), qui est configurée pour générer un signal de sécurité électrique,
- un dispositif de surveillance (3) doté d'une entrée de surveillance (3a), qui est configuré pour surveiller si le signal de sécurité est appliqué à l'entrée de surveillance (3a) et, dans le cas où le signal de sécurité n'est pas appliqué à l'entrée de surveillance (3a), régler l'état opérationnel sécurisé, et
- un circuit imprimé (4) comprenant :
- au moins une couche interne,
- une portion formant pont (5), la portion formant pont (5) étant séparée du circuit imprimé (4) lors de l'application d'une force à des points de rupture voulus (6), et
- une piste conductrice (7) qui s'étend sur la couche interne, laquelle est incorporée entre la source de signal de sécurité (2) et l'entrée de surveillance (3a) du dispositif de surveillance (3) et laquelle passe sur la portion formant pont (5) de telle sorte qu'une liaison de signal entre la source de signal de sécurité (2) et l'entrée de surveillance (3a) du dispositif de surveillance (3) est interrompue lorsque la portion formant pont (5) est séparée du circuit imprimé (4),
**caractérisé en ce que**
- le circuit imprimé (4) possède un connecteur à enfichage direct de circuit imprimé (9) adjacent à la portion formant pont (5), sur lequel peut être enfiché un module de sécurité (14) lorsque la portion formant pont (5) est séparée du circuit imprimé (4), un pôle de raccordement (9a) du connecteur à enfichage direct de circuit imprimé (9) étant relié électriquement à l'entrée de surveillance (3a) du dispositif de surveillance (3).

2. Contrôleur électrique selon la revendication 1, **caractérisé en ce que**
- les points de rupture voulus (6) sont prédéfinis dans le circuit imprimé (4) au moyen de rainurages ou de fraisages (8).

3. Contrôleur électrique selon la revendication 1 ou 2, **caractérisé en ce que**
- le contrôleur électrique et un variateur de fréquence.

4. Contrôleur électrique selon l'une des revendications précédentes, **caractérisé par**
- un boîtier de contrôleur (10),
- la source de signal de sécurité (2), le dispositif de surveillance (3) et le circuit imprimé (4) étant disposés à l'intérieur du boîtier de contrôleur (10),
- le boîtier de contrôleur (10) possédant une portion de boîtier (11) munie d'une ouverture (12), et
- le circuit imprimé (4) possédant une ouverture (13) qui, lorsque le circuit imprimé (4) est disposé dans le boîtier de contrôleur (10), correspond géométriquement avec l'ouverture (12) du boîtier de contrôleur de telle sorte qu'un outil peut être inséré à la fois à travers l'ouverture (12) du boîtier de contrôleur (10) et à travers l'ouverture (13) du circuit imprimé (4), de sorte que la portion formant pont (5) et la portion de boîtier (11) peuvent être soumises à une force au moyen de l'outil, lors de l'application d'une force, la portion formant pont (5) étant séparée du circuit imprimé (4) et la portion de boîtier (11) étant séparée du boîtier de contrôleur (10).

5. Système contrôleur, comprenant
- un contrôleur électrique (1) selon l'une des revendications 1 à 4, et
- un module de sécurité (14) destiné à être enfiché sur le connecteur à enfichage de circuit imprimé (9) du contrôleur (1),
- le module de sécurité (14) étant configuré pour générer le signal de sécurité en fonction de signaux relatifs à une fonction de sécurité de telle sorte que l'état opérationnel sécurisé ou l'état opérationnel normal est produit.
